Europäisches Patentamt

European Patent Office

Office européen des brevets

(19)

(11) Veröffentlichungsnummer: **0 293 630**
**A1**

(12) # EUROPÄISCHE PATENTANMELDUNG

(21) Anmeldenummer: **88107287.0**

(22) Anmeldetag: **06.05.88**

(51) Int. Cl.⁴: **H01L 23/14 , H01L 23/36 , H01L 29/86**

Die Bezeichnung der Erfindung wurde geändert (Richtlinien für die Prüfung im EPA, A-III, 7.3).

(30) Priorität: **04.06.87 DE 3718684**

(43) Veröffentlichungstag der Anmeldung:
**07.12.88 Patentblatt 88/49**

(84) Benannte Vertragsstaaten:
**DE FR GB IT**

(71) Anmelder: **Licentia Patent-Verwaltungs-GmbH**
**Theodor-Stern-Kai 1**
**D-6000 Frankfurt/Main 70(DE)**

(72) Erfinder: **Behr, Wolfgang, Dipl.-Phys.**
**Gänsackerweg 9**
**D-7915 Thalfingen(DE)**
Erfinder: **Strohm, Karl, Dr.**
**Bei der Pilzbuche 40**
**D-7900 Ulm(DE)**
Erfinder: **Luy, Johann-Friedrich, Dipl.-Ing.**
**Schermarweg 3,**
**D-7900 Ulm(DE)**

(74) Vertreter: **Amersbach, Werner, Dipl.-Ing. et al**
**Licentia Patent-Verwaltungs-GmbH**
**Theodor-Stern-Kai 1**
**D-6000 Frankfurt 70(DE)**

(54) **Halbleiterkörper mit Wärmesenke.**

(57) Die Erfindung betrifft einen Halbleiterkörper, der aus mindestens einem Halbleiterbauelement (12), insbesondere einer Impattdiode, mit integrierter Wärmesenke (9) besteht. Die Halbleiterschichtenfolge, aus der das Halbleiterbauelement hergestellt ist, besteht aus einer ersten $p^+$-dotierten Halbleiterschicht (2), die gleichzeitig die Funktion einer Ätzstoppschicht, einer Kontaktschicht und einer Pufferschicht innehat.

EP 0 293 630 A1

FIG. 1

"Halbleiterkörper"

Die Erfindung betrifft einen Halbleiterkörper nach dem Oberbegriff des Patentanspruchs 1.

Die Erfindung ist insbesondere für Halbleiterbauelemente geeignet, die als Impattdioden ausgebildet sind. Derartige Halbleiterbauelemente werden zur Herstellung von mm-Wellensendern verwendet.

Der Aufbau von Halbleiterkörpern, bestehend aus einem Halbleiterbauelement und einer Wärmesenke, erfolgt sowohl in hybrider wie in integrierter Bauweise. Diskrete Halbleiterbauelemente, insbesondere Impattdioden, mit seperater Wärmesenke werden hybrid in HF-Schaltungen eingebaut (Lit.: E. Kasper et al, IEEE Trans. Electron. Dev., Vol. ED-34, Nr. 5, 1987).

Eine derartige hybride Bauweise von Halbleiterkörpern hat insbesondere bei industrieller Massenfertigung den Nachteil, daß sie zeit- und kostenaufwendig ist.

In der US-PS 40 91 408 ist ein Aufbau einer Impattdiode mit integrierter Wärmesenke angegeben, wobei die Impattdiodenstruktur im Substrat durch Ionenimplantation hergestellt wird. Die Herstellung der Bauelementstruktur im Substrat durch Ionenimplantation hat den Nachteil, daß auf dem Substrat eine zusätzliche, geeignet strukturierte Oxidschicht aufgebracht werden muß. Weiterhin ist von Nachteil, daß mit dem Implantationsverfahren dünne Halbleiterschichten nicht herstellbar sind.

Der Erfindung liegt daher die Aufgabe zugrunde, einen monolithisch integrierbaren Halbleiterkörper für mm-Wellensender anzugeben, der kostengünstig, technisch einfach und zuverlässig herstellbar ist.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein Vorteil der Erfindung besteht darin, daß mehrere Halbleiterbauelemente aus der auf dem Halbleitersubstrat aufgewachsenen Halbleiterschichtenfolge herstellbar sind und komplexe, monolithisch integrierte Schaltungen aufgebaut werden können.

Weiterhin ist vorteilhaft, daß Halbleiterstrukturen mit sehr dünnen, nahezu defektfreien Halbleiterschichten epitaktisch gewachsen werden und dadurch mm-Wellen-Bauelemente, z. B. Impattdioden mit Quasi-Read-Struktur, für Frequenzen mit mehr als 60 GHz herstellbar sind.

Die Erfindung wird im folgenden an Ausführungsbeispielen näher erläutert unter Bezugnahme auf schematische Zeichnungen.

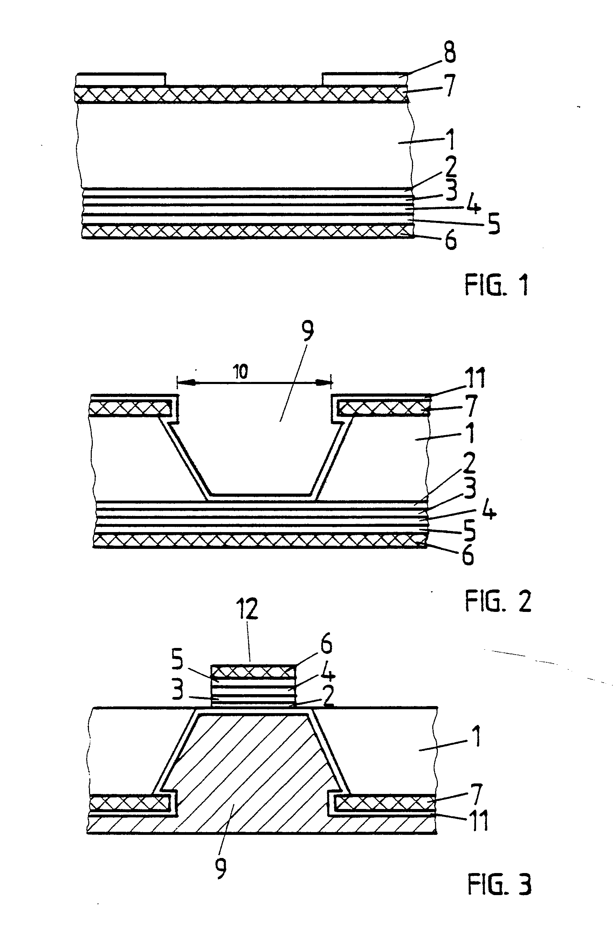

Die Fig. 1 bis 3 zeigen die Herstellung des erfindungsgemäßen Halbleiterkörpers.

Gemäß Fig. 1 ist auf einem hochohmigen ( 3000 $\Omega$cm) Silizium(Si)-Substrat, das beidseitig z.B. auf eine Enddicke von 200 $\mu$m poliert ist, eine Halbleiterschichtenfolge epitaktisch aufgewachsen. Zur Herstellung beispielsweise einer Doppeldrift-Impattdiode besteht die Halbleiterschichtenfolge aus

- einer $p^+$-dotierten Si-Schicht 2 mit einer Schichtdicke von 2.0 $\mu$m und einer Ladungsträgerkonzentration von mehr als $7 \bullet 10^{19}$ cm$^{-3}$,
- einer p-dotierten Si-Schicht 3 mit einer Schichtdicke von 0,35 $\mu$m und einer Ladungsträgerkonzentration von ungefähr $2 \bullet 10^{17}$ cm$^{-3}$,
- einer n-dotierten Si-Schicht 4 mit einer Schichtdicke von 0,35 $\mu$m und einer Ladungsträgerkonzentration von ungefähr $2 \bullet 10^{17}$ cm$^{-3}$, und
- einer $n^+$-dotierten Si-Schicht 5 mit einer Schichtdicke von 0,2 $\mu$m und einer Ladungsträgerkonzentration von mehr als $2 \bullet 10^{19}$ cm$^{-3}$.

Als Dotiermaterialien werden für die $p^+$-dotierte Si-Schicht 2 Bor, für die p-dotierte Si-Schicht 3 Gallium und für die n-dotierten Si-Schichten 4, 5 Antimon verwendet.

Auf die Halbleiterschichtenfolge ist eine erste Metallisierungsschicht 6 und auf der der Halbleiterschichtenfolge entgegengesetzten Seite des Halbleitersubstrates 1 ist eine zweite Metallisierungsschicht 7 aufgebracht. Die Metallisierungsschichten 6, 7 bestehen z.B. aus einer 0,1 $\mu$m dicken Haftvermittlerschicht aus Titan und einer 0,3 $\mu$m dicken Goldschicht.

Zur Herstellung der Wärmesenke 9 wird auf die zweite Metallisierungsschicht 7 eine Fotolackschicht 8 aufgebracht und durch geeignete Ätzverfahren ein Fenster 10 in der zweiten Metallisierungsschicht 7 erzeugt. Die Fotolackschicht 8 wird anschließend entfernt. Mit einer anisotropen Ätze, z.B. KOH, wird das Si-Substrat 1 geätzt. Der Ätzvorgang stoppt an der $p^+$-dotierten Si-Schicht 2, die durch ihre hohe Dotierkonzentration als Ätzstoppschicht wirkt. Die anisotrope Ätze bewirkt, daß der Ätzvorgang senkrecht zur Substratoberfläche schneller vonstatten geht als parallel zur Substratoberfläche. Dadurch bildet sich eine pyramidenstumpfförmige Wärmesenke 9 aus (Fig. 2).

Auf die Wandung der Wärmesenke 9 und die zweite Metallisierungsschicht 7 ist eine dritte Metallisierungsschicht 11 abgeschieden, die aus einer 0,1 $\mu$m dicken Haftvermittlerschicht aus Chrom und einer 0,1 $\mu$m dicken Goldschicht besteht. Anschließend wird die Wärmesenke 9 mit einem wärmeleitenden Metall, z.B. Gold, galvanisch gefüllt. Um eine geeignete Rückseitenkontaktierung des Halbleiterbauelements 12 zu gewährleisten, wird die dritte Metallisierungsschicht 11 mit Gold galvanisch verstärkt.

Die Strukturierung des Halbleiterbauelements 12, z.B. als Doppeldrift-Impattdiode in Mesabauweise, erfolgt durch bekannte Fotoprozesse und Ätzverfahren (Fig. 3).

Bei der integrierten Bauweise ist das Halbleiterbauelement 12 auf die Wärmesenke 9 genau justierbar, da die Goldfüllung der Wärmesenke 9 durch die dünnen epitaktisch aufgewachsenen Halbleiterschichten sichtbar ist.

Eine weitere Ausführungsform des Halbleiterbauelements 12 besteht darin, daß die erste Halbleiterschicht der vorher beschriebenen Halbleiterschichtenfolge aus einer $p^+$-dotierten Si-Schicht 2 besteht, die jedoch nicht nur mit Bor dotiert ist, sondern mit Bor und Germanium. Die Schichtdicke dieser $p^+$-dotierten Si-Schicht 2 beträgt ungefähr 2 $\mu$m und die Bor-Dotierkonzentration ist größer als $7 \times 10^{19}$ cm$^{-3}$.

Die hohe Bor-Konzentration verursacht, bedingt durch den kleineren kovalenten Radius von Bor (0,088nm) gegenüber Silizium (0,117nm), hohe Spannungen und Gitter - fehlanpassungsversetzungen in der $p^+$-dotierten Si-Schicht 2 und führt dadurch beim epitaktischem Wachstum der nachfolgenden aktiven Si-Schichten 3, 4 und 5 zu erhöhter Defektbildung. Durch den gleichzeitigen Einbau von Atomen mit einem größeren kovalenten Radius als Silizium, z.B. von elektrisch inaktivem Germanium, mit einem kovalenten Radius von 0,122 nm, lassen sich defektfreie und spannungsfreie Halbleiterschichten herstellen. Auf solchen spannungskompensierten und defektfreien Halbleiterschichten lassen sich in vorteilhafterweise die nachfolgenden Si-Schichten 3, 4 und 5 defektfrei abscheiden.Dadurch wirkt die mit Bor und Germanium $p^+$-dotierte Si-Schicht 2 als Pufferschicht zwischen Halbleitersubstrat 1 und den nachfolgenden Halbleiterschichten 3, 4, 5. Weiterhin besitzt die mit Bor und Germanium $p^+$-dotierte Si-Schicht 2 durch die hohe Bordotierung eine sehr geringe Ätzrate für anisotropesÄtzen, wie z.B. KOH, und eignet sich in vorteilhafterweise als Ätzstoppschicht bei der Herstellung der Wärmesenke 9. Ferner läßt sich durch die mögliche hohe Bor-Dotierung ein guter ohmscher Kontakt mit geringem Kontaktwiderstand für das Halbleiterbauelement 12 erzielen.

Die Dotierung von Si-Schichten mit Bor und Germanium zur Erzeugung spannungsfreier Halbleiterschichten ist in der DE-OS 34 25 063 beschrieben.

Der erfindungsgemäße Halbleiterkörper ist so aufgebaut, daß das integrierte Halbleiterbauelement, z. B. eine Doppeldrift-Impattdiode, beidseitig kontaktierbar ist. Die erste Metallisierungsschicht 6 ist als Vorderseitenkontakt des Halbleiterbauelements ausgebildet. Die Rückseite des Halbleiterbauelementes ist über die $p^+$-dotierte Si-Schicht 2 und die mit Gold galvanisch verstärkte dritte Metallisierungsschicht 11 kontaktierbar.

Der erfindungsgemäße Halbleiterkörper ist in komplexe Schaltungen, insbesondere HF-Schaltungen, monolithisch integrierbar. Als monolithisch integriertes Halbleiterbauelement können Impattdioden mit der beschriebenen $p^+pnn^+$-Struktur (Doppeldriftdioden) oder mit einer $p^+nn^+$-Struktur (Einfachdriftdioden) oder mit einer Quasi-Read-Struktur verwendet werden.

Eine Impattdiode mit Quasi-Read-Doppeldrift-Struktur besteht beispielsweise aus einer Halbleiterschichtenfolge aus
- einer $p^+$-dotierten Si-Schicht mit einer Schichtdicke von 1,5 $\mu$m und einer Ladungsträgerkonzentration von $10^{20}$ cm$^{-3}$,
- einer p-dotierten Si-Schicht mit einer Schichtdicke von 0,37 $\mu$m und einer Ladungsträgerkonzentration von $1,3 \bullet 10^{17}$ cm$^{-3}$,
- einer $n^+$-dotierten Si-Schicht mit einer Schichtdicke von 35 nm und einer Ladungsträgerkonzentration von $10^{20}$ cm$^{-3}$,
- einer n-dotierten Si-Schicht mit einer Schichtdicke von 0,22 $\mu$m und einer Ladungsträgerkonzentration von $0,6 \bullet 10^{17}$ cm$^{-3}$ und
- einer $n^+$-dotierten Si-Schicht mit einer Schichtdicke von 0,2 $\mu$m und einer Ladungsträgerkonzentration von $3 \bullet 10^{19}$ cm$^{-3}$.

Die Kontaktierung und die Herstellung der entsprechenden Wärmesenken für eine derartige Quasi-Read-Doppeldrift-Diode erfolgt wie oben beschrieben. Zur Herstellung einer defektfreien Bauelementschichtenfolge ist es vorteilhaft, die $p^+$-dotierte Si-Schicht aus den oben genannten Gründen mit Bor und Germanium zu dotieren.

Die Halbleiterschichtenfolge zur Herstellung des Halbleiterbauelements ist mit der Molekularstrahl-Epitaxie aufgewachsen.

Die Erfindung ist nicht auf die beschriebenen Ausführungsbeispiele beschränkt, sondern die Halbleiterschichtenfolge zur Herstellung des Halbleiterbauelements kann beispielsweise eine Si/SiGe-Übergitter-Struktur besitzen. Außerdem kann die Halbleiterschichtenfolge aus III/V-Verbindungshalbleitern aufgebaut sein.

## Ansprüche

1. Halbleiterkörper, bestehend aus mindestens einem Halbleiterbauelement, insbesondere einer Impattdiode, das auf einer Wärmesenke aufgebracht ist, wobei Halbleiterbauelement und Wärmesenke in eine Schaltung monolithisch integrierbar sind, dadurch gekennzeichnet,

- daß auf einem Halbleitersubstrat (1) eine Halbleiterschichtenfolge aufgewachsen ist, aus der das Halbleiterbauelement (12) hergestellt ist,
- daß die auf das Halbleitersubstrat (1) aufgewachsene erste Halbleiterschicht der Halbleiterschichtenfolge derart dotiert ist, daß die erste Halbleiterschicht als Ätzstoppschicht und/oder Pufferschicht ausgebildet ist, und
- daß im Halbleitersubstrat (1) eine Wärmesenke (9) ausgebildet ist, auf die das Halbleiterbauelement (12) aufgebracht ist.

2. Halbleiterkörper nach Anspruch 1, dadurch gekennzeichnet, daß das Halbleitersubstrat (1) aus hochohmigem Silizium besteht.

3. Halbleiterkörper nach einem der vorhergehenden Ansprüche, dadurch gekennzeichnet, daß die erste Halbleiterschicht der Halbleiterschichtenfolge eine $p^+$-dotierte Silizium-Schicht (2) ist.

4. Halbleiterkörper nach einem der vorhergehenden Ansprüche, dadurch gekennzeichnet, daß das Dotiermaterial der $p^+$-dotierten Silizium-Schicht (2) Bor ist.

5. Halbleiterkörper nach einem der Ansprüche 1 bis3, dadurch gekennzeichnet, daß die Dotiermaterialien der $p^+$-dotierten Silizium-Schicht (2) Bor und Germanium sind.

6. Halbleiterkörper nach einem der vorhergehenden Ansprüche, dadurch gekennzeichnet, daß auf die Halbleiterschichtenfolge eine erste Metallisierungsschicht (6) und auf der der Halbleiterschichtenfolge entgegengesetzten Seite des Halbleitersubstrates(1) eine zweite Metallisierungsschicht (7) aufgebracht ist.

7. Halbleiterkörper nach einem der vorhergehenden Ansprüche, dadurch gekennzeichnet,
- daß in die zweite Metallisierungsschicht (7) ein Fenster (10) eingebracht ist,
- daß in das Halbleitersubstrat (1) eine Vertiefung geätzt ist, derart, daß die Ätze an der $p^+$-dotierten Silizium-Schicht (2) stoppt, und
- daß die Vertiefung mit einem wärmeleitenden Metall aufgefüllt ist und als Wärmesenke (9) und Rückseitenkontakt für das Halbleiterbauelement (12) ausgebildet ist.

8. Halbleiterkörper nach einem der vorhergehenden Ansprüche, dadurch gekennzeichnet, daß die Wärmesenke (9) aus Gold besteht.

9. Halbleiterkörper nach einem der vorhergehenden Ansprüche, dadurch gekennzeichnet, daß das Halbleiterbauelement (12) als beidseitig kontaktierbare Impattdiode ausgebildet ist.

10. Halbleiterkörper nach einem der vorhergehenden Ansprüche, dadurch gekennzeichnet, daß der Halbleiterkörper in HF-Schaltungen monolithisch integrierbar ist.

FIG. 1

FIG. 2

FIG. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | US-A-4 091 408 (HUGHES AIRCRAFT) <br> * Ansprüche 1,7; Figur 12 * <br> --- | 1,2,4,6 ,7,9,10 | H 01 L 23/14 <br> H 01 L 23/36 <br> H 01 L 29/86 |
| A | GB-A-2 067 354 (AEI) <br> * Zusammenfassung * <br> --- | 6,9,10 | |
| A | PROCEEDINGS OF THE 5TH BIENNIAL CORNELL ELECTRICAL ENGINEERING CONFERENCE, 19.-21. August 1975, Ithaca, New York, Seiten 367-376; R.E. GOLDWASSER et al.: "Highly reliable pulsed GaAs read diodes" <br> * Figur 4 * <br> --- | 3,8,9 | |
| D,A | EP-A-0 167 948 (TELEFUNKEN) <br> * Zusammenfassung * <br> --- | 4,5 | |
| A | EP-A-0 154 431 (AMERICAN TELEPHONE AND TELEGRAPH) <br> --- | | |
| A | EP-A-0 079 265 (THOMSON) <br> --- | | RECHERCHIERTE SACHGEBIETE (Int. Cl.4) |
| A | GB-A-2 046 514 (RAYTHEON) <br> --- | | H 01 L |
| A | US-A-4 374 394 (RCA) <br> ----- | | |

Der vorliegende Recherchenbericht wurde für alle Patentansprüche erstellt

| Recherchenort | Abschlußdatum der Recherche | Prüfer |
|---|---|---|
| DEN HAAG | 19-08-1988 | DE RAEVE R.A.L. |